# EUROPEAN PATENT SPECIFICATION

(11) **EP 1 482 549 B1**
(45) Date of publication and mention of the grant of the patent: **30.03.2011**
(21) Application number: 03291284.2
(22) Date of filing: 27.05.2003
(51) Int. Cl.: H01L 21/762, C30B 25/18, C30B 33/00

(54) **Method of fabrication of a heteroepitaxial microstructure**
Verfahren zur Herstellung einer heteroepitaktischen Mikrostruktur
Procédé pour la fabrication d'une microstructure heteroepitaxiale

(43) Date of publication of application: 01.12.2004
(73) Proprietor: S.O.I. Tec Silicon on Insulator Technologies S.A., 38190 Bernin (FR)
(72) Inventor: Faure, Bruce, 38000 Grenoble (FR); Letertre, Fabrice, 38000 Grenoble (FR)
(74) Representative: Grünecker, Kinkeldey, Stockmair & Schwanhäusser Anwaltssozietät

(56) References cited:
- EP-A- 0 971 395
- WO-A-02/43112
- DE-A- 19 753 494
- FR-A- 2 797 713
- FR-A- 2 830 983
- US-A1- 2002 072 130

## Description

The present invention relates to a method of fabricating a microstructure, especially a heteroepitaxial microstructure in which an epitaxial layer is formed on a surface of a carrier structure. It further relates to a microstructure, especially a heteroepitaxial microstructure, comprising a carrier structure having a surface on which an epitaxial layer is formed.

EP 9 71395 A1 discloses a method for fabricating a silicon-on-insulator wafer in which a silicon epitaxial layer is formed on the surface of a carrier structure, formed by a splitting process prior to epitaxial deposition. WO 02/43112 discloses a method for making a substrate comprising the steps of transferring a seed layer onto a support by molecular adhesion at the bonding interface, epitaxial growth of a useful layer on the seed layer and applying stress to produce removal of the formed assembly from the seed layer and the useful layer relative to the support at the bonding interface.

It is known from prior art to fabricate crystalline microstructures having an epitaxial gallium nitride layer on an α-Al₂O₃ substrate, wherein an aluminum nitride buffer layer is used between the gallium nitride and the α-Al₂O₃ to reduce the lattice constant mismatch between these materials. It is further possible to provide a gallium nitride layer with and without buffer layers on a base substrate of silicon carbide, silicon or another material compatible with gallium nitride epitaxy.

It is also known to produce SiGe layers by epitaxial growth on flat surfaces.

To produce such a microstructure, a smoothly finished surface of the base substrate is necessary to obtain a good crystal quality of the deposited layer. Therefore, it has been necessary to prepare the corresponding base substrate surfaces in lengthy, low-efficiency, polishing steps in order to obtain a very low surface roughness. Such polishing steps are particularly difficult when hard materials like SiC are to be polished.

Thin, very hard materials such as silicon carbide can only be polished with a very low efficiency. They are normally provided with an increased surface roughness and defects like surface scratches, which fact has lead to the opinion that SiC substrates are not suitable for fabricating high quality heteroepitaxial structures, such as structures with a gallium nitride layer.

It is therefore the object of the present invention to provide a more efficient method for fabricating a microstructure, especially a heteroepitaxial microstructure, with high crystal quality and a high degree of surface smoothness, and to provide a high quality microstructure with a smooth surface which can be fabricated efficiently.

The object is solved by a method as set forth in claim 1 of the above-mentioned type in which the surface of the carrier structure is created by splitting said carrier structure prior to the forming of the epitaxial layer. Surprisingly, said split surface, which normally has an increased surface roughness, is especially well-suited for forming an epitaxial layer with a high crystal quality and an excellent level of smoothness. The inventive method has the advantage that a just split carrier structure as well as a treated split carrier structure can be used as a base structure for the preparation of the epitaxial layer which reduces the time and the effort needed for fabricating the microstructure.

In a favourable embodiment of the invention, the split carrier surface is produced in a splitting process comprising implantation of species into the carrier structure and thermal annealing of the implanted structure. By this method, the characteristics of the split carrier surface can be controlled by adjusting the parameters of the splitting process, such as the implantation dose used, the species chosen, the backing method used or the annealing parameters, which can lead to a defined morphology of said surfaces. The final splitting can be accompanied by a mechanical step.

In a preferable example of the invention, the epitaxial layer comprises at least one material of the group consisting of aluminum nitride, gallium aluminum nitride, silicon germanium, germanium, InGaN and gallium nitride. It has been shown that these layers grow especially well on the split carrier surface.

It is further advantageous when the carrier structure comprises at least one material of the group consisting of sapphire, silicon carbide, silicon, germanium, gallium arsenide, lithium gallate, indium phosphide, lithium aluminate, ZnO, aluminum nitride and gallium nitride. These materials can be easily split and are appropriate for an epitaxial formation of a crystalline layer thereon.

Preferably, the epitaxial layer is used as a buffer layer on which a second epitaxial layer is formed. By means of the buffer layer, a lattice constant mismatch between the carrier substrate and the second epitaxial layer can be reduced, resulting in a high quality formation of the second epitaxial layer.

In a beneficial variant of the present invention, the second epitaxial layer comprises gallium nitride. This method results in a high-quality microstructure which can be very attractive for many electronic and opto-electronic devices. The wide, direct energy band gap of the nearly-perfect gallium nitride which can be formed by the inventive method makes it suitable, for instance, for short wave length emitters and detectors. And its good thermal stability is advantageous for high temperature and high power electronics. Gallium nitride can be combined in an alloy with InGaN, and/or AlGaN, or be combined with layers of the materials together forming the second epitaxial layer.

In a further beneficial variant of the present invention, the second epitaxial layer comprises relaxed silicon germanium. GeSi can be combined with other layers of materials such as strained silicon or germanium together forming the second epitaxial layer.

The object of the invention related to a microstructure, especially a heteroepitaxial microstructure of the above-mentioned type, wherein the carrier surface is a surface formed by splitting.

Although any split surface normally has an increased surface roughness, this surface in particular is surprisingly very well-suited for creating the epitaxial layer thereon with a high quality. It has been shown that the epitaxial layer can be formed on the split carrier surface very easily and with a resulting low thickness, so that the microstructure can be produced with high efficiency.

In a preferable example of the invention, the carrier structure comprises at least one material of the group consisting of sapphire, silicon carbide, silicon, gallium arsenide, lithium gallate, lithium aluminate, ZnO, aluminum nitride, germanium, indium phosphide, and gallium nitride. These materials can provide good splitting characteristics, leading to split carrier surfaces on which the epitaxial layer can be formed with high quality. Some of the specified materials further have the advantage that they are compatible materials for a gallium nitride epitaxy, so that they can be effective for formation of epitaxial gallium nitride with a good crystallinity.

In a further advantageous embodiment of the invention, the epitaxial layer comprises at least one material of the group consisting of aluminum nitride, gallium aluminum nitride, InGaN and gallium nitride. These materials show very good growth characteristics on the split carrier surface.

According to a preferable variant of the invention, the split surface has a surface roughness with RMS values of about 5 Å to 150 Å, especially 20 Å to 100 Å or 20 Å to 60 Å. This roughness allows a very good nucleation, providing a high-quality growth of the epitaxial layer on this surface.

It is particularly favourable when the carrier structure is a composite structure, comprising at least a base wafer and a single crystalline top layer having the split surface. In this microstructure, the crystalline top layer can accommodate very well strain caused by a lattice constant mismatch between the base wafer and the epitaxial layer.

In a further advantageous embodiment of the invention, the epitaxial layer is a buffer layer on which a second epitaxial layer is formed. Such a buffer layer is especially favourable for compensating for a lattice constant mismatch between the carrier structure and the second epitaxial layer.

Preferably, the epitaxial layer comprises gallium nitride. This material has very good electronic properties, so that the resulting microstructure can be used with ease in many electronic and opto-electronic devices.

The present invention will be more apparent from the following detailed description with reference to the accompanying figures in which:
Fig. 1 to Fig. 10 show schematically typical process steps to produce an example of a microstructure according to the present invention. Specifically,
   - Fig. 1: shows one of the substrates used to form a carrier structure as applied in the present invention;
   - Fig. 2: shows another substrate used to form a carrier structure as applied in the present invention, wherein the substrate is implanted;
   - Fig. 3: shows a bonded wafer pair consisting of the substrates shown in Figs. 1 and 2, used to form a carrier structure as applied in the present invention;
   - Fig. 4: shows the bonded wafer pair of Fig. 3 during an annealing step which is used to form a split carrier structure as applied in the present invention;
   - Fig. 5: shows a split part of the bonded wafer pair of Fig. 4, used as a carrier structure for the present invention;
   - Fig. 6: shows another split part of the bonded wafer pair of Fig. 4, used as another carrier structure for the present invention;
   - Fig. 7: shows the carrier structure of Fig. 5 after forming epitaxial buffer layer thereon to form a microstructure;
   - Fig. 8: shows the carrier structure of Fig. 6 after forming an epitaxial buffer layer thereon to form another microstructure;
   - Fig. 9: shows the microstructure of Fig. 7 after forming a monocrystalline second epitaxial layer thereon; and
   - Fig. 10: shows the microstructure of Fig. 8 after forming a monocrystalline second epitaxial layer thereon.

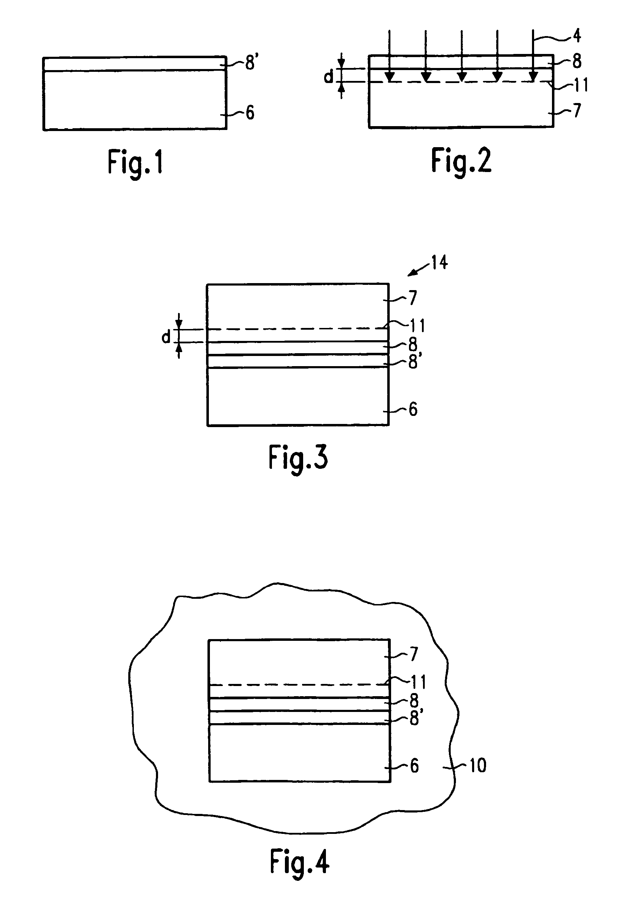

Fig. 1 shows a substrate used to form a carrier structure as applied in the present invention. The substrate of Fig. 1 comprises a wafer 6 of sapphire, silicon carbide, silicon, gallium arsenide, lithium gallate, lithium aluminate, zinc oxide, aluminum nitride or gallium nitride. In the embodiment shown, an oxide layer 8' is formed on the wafer 6. In other embodiments (not shown) this oxide layer 8' can be omitted or can be of another insulating material.
Fig. 2 shows another substrate used to form a carrier structure as applied in the present invention. The substrate of Fig. 2 consists of a wafer 7 having on top an oxide layer 8. In other embodiments (not shown) this oxide layer 8 can be omitted or can be of another insulating material.
Through the oxide layer 8, species 4, for example hydrogen ions and/or rare gases are implanted in the wafer 7. Both dose and energy of the implanted species are so adjusted that a peak of concentration of the implanted species 4 is formed at a certain depth d of the wafer 7, forming there a weakened layer introduced by ion implantation 11 at or near this depth *d*.
Fig. 3 shows a bonded wafer pair consisting of the substrates shown in Figs. 1 and 2. The wafer pair is used as a base structure 14 to form a carrier structure as applied in the present invention. The base structure 14 consists of two wafers 6, 7 which are bonded together using the insulator layers 8, 8' therebetween. In another embodiment of the present invention (not shown), the wafers 6, 7 are bonded directly so that the insulator layers 8, 8' can be omitted or just one insulator layer 8.8' can be omitted
Fig. 4 shows the structure of Fig. 3 during an annealing step wherein the base structure 14 is annealed in a hot environment 10 such as a furnace or any equipment for rapid thermal annealing. The effect of temperature and annealing time results in a weakening of the implanted base structure 14 at the defect layer 11 introduced by atomic implantation which might lead to splitting. By splitting along this region 11, one carrier structure 1 and a residual wafer part 9, which can also be used as a carrier structure for the present invention, are formed.

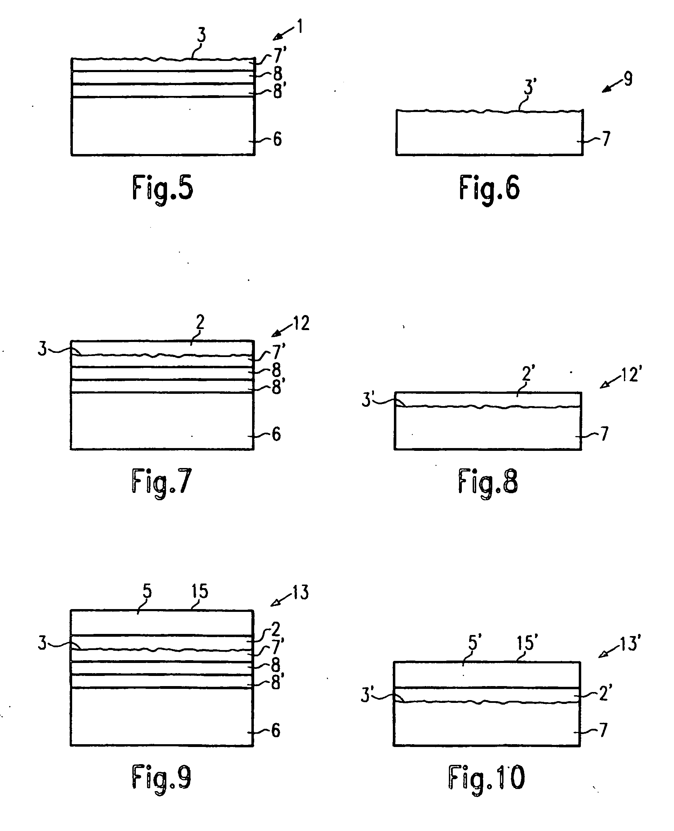

Fig. 5 shows the split carrier structure 1 consisting of the wafer 6, the insulator layers 8, 8' and a residual part 7' of the former wafer 7. The carrier structure 1 has a relatively rough but homogeneous splitting surface 3. Typical RMS-values of that roughness are about 5 Å to 150 Å, especially 20 Å to 100 Å or 20 Å to 60 Å.
Fig. 6 shows the other carrier structure 9 formed by the splitting process of Fig. 4. The carrier structure 9 consists of the remaining part of the former wafer 7, having a surface 3' with an increased but homogeneous surface roughness. In a further embodiment of the present invention (not shown), the roughness of the split surface 3 can be reduced by an additional step after splitting and before growth of a crystalline layer on the surface 3. This additional step can be oxidation and de-oxidation, chemical-mechanical polishing, etching by gas cluster, ion beam or reactive ion etching, HCL-smoothing or a combination of at least two of these steps. For example, the surface 3 can be treated with a thermal oxidation wherein the oxide is removed thereafter and the surface is finished with a final chemical-mechanical polishing step to a certain degree. This way, the roughness of the surface 3 can be adjusted over a wide range of roughness values. The power spectral distribution of the roughness can be shaped by the splitting parameters and/or subsequent treatment steps. The roughness of the splitting surface 3 is, even directly after splitting, relatively homogeneous. When the split surface 3 is treated with at least one of the above-mentioned additional steps, the surface roughness can be tuned from a high roughness value of the just-split surface to a low roughness value, wherein the homogeneity of the overall roughness of the surface 3 is maintained. After a thermal treatment, an ion treatment or a chemical-mechanical polishing, the carrier surface 3 has a roughness with RMS values of about 5 Å up to the roughness values of the split surface 3 directly after splitting.
Fig. 7 shows a microstructure 12 formed by an epitaxial growth of a layer 2 on the rough carrier surface 3 of the carrier structure 1. The epitaxial layer 2 consists of aluminum nitride, gallium aluminum nitride or gallium nitride. The epitaxial layer 2 has a thickness of from about 20 nm to 500 nm and may be a buffer layer.
Fig. 8 shows the carrier structure 9 of Fig. 6, on which a polycrystalline layer 2' has been formed on the rough carrier surface 3'. The epitaxial layer 2' consists of aluminum nitride, gallium aluminum nitride or gallium nitride. The epitaxial layer 2' has a thickness from 20 nm to 500 nm. A chemical-mechanical polishing step can be added, if necessary, between the growth of epitaxial layer 2 and epitaxial layer 5.
Fig. 9 shows a further microstructure 13 formed by a growth of a monocrystalline second epitaxial layer 5 on the epitaxial layer 2 of the microstructure 12 of Fig. 7. The second epitaxial layer 5 consists of gallium nitride. This second epitaxial layer 5 has a very good crystallinity and a very low roughness of its surface 15. Root mean square (RMS) values of the second epitaxial layer 5 are typically between 0.5 and 4 Å.
Fig. 10 shows a further microstructure 13' formed by a growth of a monocrystalline second epitaxial layer 5' on the epitaxial layer 2' of the microstructure 12' of Fig. 8. The second epitaxial layer 5' consists of gallium nitride and has a very good crystallinity and a very low level of roughness of its surface 15'. Root mean square (RMS) values of the second epitaxial layer 5' are typically between 0.5 and 4 Å.

An example of a method according to an embodiment of the present invention is described below with reference to Figs. 5, 7 and 9.

Fig. 5 shows the just-split carrier structure 1 with which the method is started. In comparison to the very smooth surfaces of the substrates used for an epitaxial growth in the prior art, the surface 3 of the carrier structure 1 remains untreated after splitting. That means this surface 3 will not be polished or otherwise treated to reduce the surface roughness of the surface 3. However, this does not exclude any further step such as a cleaning of that surface 3 after splitting.

In another embodiment of the present invention (not shown), the surface 3 is treated after splitting to reduce the surface roughness. The surface treatment is performed using a thermal oxidation and oxide removal, a chemical-mechanical polishing, etching by gas cluster ion beam or reactive ion etching, or a combination of these steps.

As shown in Fig. 7, the epitaxial layer 2, such as an aluminum nitride layer, grows particularly well on the rough but homogeneous surface 3, despite the increased surface roughness of the surface 3. Characteristics of the split surface 3 are useful to grow the polycrystalline buffer layer 2 which forms a very good base to grow the monocrystalline second epitaxial layer 5 thereon.

With reference to Fig. 9, the second epitaxial layer of the microstructure 12 shown in Fig. 7 acts as a buffer layer for forming the monocrystalline second epitaxial layer 5 on that epitaxial layer 2. The epitaxial buffer layer 2 accommodates a mismatch of lattice constants between the residual part 7' of the carrier structure 1 and the grown second epitaxial layer 5. This method results in a very high crystal quality and a very smooth surface 15 of the second epitaxial layer 5.

Specifically, the resulting microstructure 13 preferably consists of an α-Al₂O₃ or SiC base wafer 6, silicon dioxide insulator layers 8, 8' thereon, and a residual part 7' of a further α-Al₂O₃ wafer 7. On the split surface 3 of the layer 7', a thin aluminum nitride layer 2 is formed, and the layer thereon is a monocrystalline gallium nitride layer 5.

## Claims

1. The method of fabricating a heteroepitaxial microstructure, in which an epitaxial layer (2) is formed on a surface (3) of a carrier structure (1), implanting species into the carrier structure, and the surface (3) of carrier structure (1) is created by splitting said carrier structure (1) by a thermal annealing prior to forming of the epitaxial layer (2)
**characterised in that**
surface characteristics of the split carrier surface (3) are controlled by adjusting parameters of the splitting process.

2. The method of claim 1,
**characterised in that**
an implantation dose of species (4) implanted into the carrier structure (1) is adjusted to control the characteristics of the split carrier surface (3).

3. The method of claims 1 or 2,
**characterised in that**
species (4) implanted into the carrier structure (1) are chosen to control the characteristics of the split carrier surface (3).

4. The method of claims 2 or 3,
**characterised in that**
parameters of thermal annealing of the implanted carrier structure (1) are adjusted to control the characteristics of the split carrier surface (3).

5. The method of one of the preceding claims,
**characterised in that**
the carrier structure (1) is just split prior to forming of the epitaxial layer (2).

6. The method of one of the preceding claims,
**characterised in that**
the carrier structure (9) on which the epitaxial layer (2) is formed is a residual wafer part of a former wafer (7), a split part of which forms a layer of another bonded carrier structure (1), wherein the epitaxial layer (2') is one of AIN, GaAIN, InGaN, or GaN.

7. The method of one of the preceding claims,
**characterised in that**
the epitaxial layer (2) is used as a buffer layer on which a second epitaxial layer (5) is formed.

8. The method of claim 7,
**characterised in that**
the second epitaxial layer (5) comprises gallium nitride or gallium nitride combined in an alloy with InGaN and/or AIGaN.

9. The method of claim 7,
**characterised in that**
the second epitaxial layer (5) comprises relaxed GeSi.

## Patentansprüche

1. Verfahren zur Herstellung einer heteroepitaktischen Mikrostruktur, wobei eine epitaktische Schicht (2) auf einer Oberfläche (3) einer Trägerstruktur (1) gebildet wird, Spezien in die Trägerstruktur implantiert werden und die Oberfläche (3) der Trägerstruktur erzeugt wird, indem die Trägerstruktur (1) durch thermisches Glühen vor dem Bilden der epitaktischen Schicht (2) aufgespalten wird,
**dadurch gekennzeichnet, dass**
die Oberflächeneigenschaften der aufgespalteten Trägeroberfläche (3) durch Einstellen der Parameter des Aufspaltungsverfahrens gesteuert werden.

2. Verfahren nach Anspruch 1,
**dadurch gekennzeichnet, dass**
eine Implantationsdosis der Spezien (4), welche in die Trägerstruktur (1) implantiert werden, eingestellt wird, um die Eigenschaften der aufgespalteten Trägeroberfläche (3) zu steuern.

3. Verfahren nach Anspruch 1 oder 2,
**dadurch gekennzeichnet, dass**
die in die Trägerstruktur (1) zu implantierenden Spezien (4) gewählt werden, um die Eigenschaften der aufgespalteten Trägeroberfläche (3) zu steuern.

4. Verfahren nach Anspruch 2 oder 3,
**dadurch gekennzeichnet, dass**
die Parameter des thermischen Glühens der implantierten Trägerstruktur (1) eingestellt werden, um die Eigenschaften der aufgespalteten Trägeroberfläche (3) zu steuern.

5. Verfahren nach einem der vorangehenden Ansprüche,
**dadurch gekennzeichnet, dass**
die Trägerstruktur (1) gerade vor dem Formen der epitaktischen Schicht (2) aufgespalten wird.

6. Verfahren nach einem der vorangehenden Ansprüche,
**dadurch gekennzeichnet, dass**
die Trägerstruktur (9), auf welcher die epitaktische Schicht (2) gebildet wird, ein Restwaferteil eines vormaliegen Wafers (7) ist, wobei ein aufgespaltener Teil von diesem eine Schicht einer anderen gebundenen Trägerstruktur (1) bildet, wobei die epitaktische Schicht (2') eine aus AIN, GaAlN, InGaN oder GaN ist.

7. Verfahren nach einem der vorangehenden Ansprüche,
**dadurch gekennzeichnet, dass**
die epitaktische Schicht (2) als eine Pufferschicht verwendet wird, auf welcher eine zweite epitaktische Schicht (5) gebildet wird.

8. Verfahren nach Anspruch 7,
**dadurch gekennzeichnet, dass**
die zweite epitaktische Schicht (5) Galliumnitrit oder Galliumnitrid, welches in einer Legierung mit InGaN und/oder AlGaN kombiniert ist, umfasst.

9. Verfahren nach Anspruch 7,
**dadurch gekennzeichnet, dass**
die zweite epitaktische Schicht (5) entspanntes GeSi enthält.

## Revendications

1. Procédé de fabrication d'une microstructure hétéroépitaxiale dans laquelle une couche épitaxiée (2) est formée sur la surface (3) d'une structure de support (1) en implantant des espèces dans la structure de support, et la surface (3) de la structure de support (1) est créée en séparant ladite structure de support (1) grâce à un recuit thermique avant de former la couche épitaxiée (2),
**caractérisé en ce que**
les caractéristiques surfaciques de la surface séparée (3) du support sont contrôlées en ajustant des paramètres du processus de séparation.

2. Procédé selon la revendication 1,
**caractérisé en ce que**
une dose d'implantation d'espèces (4), implantées dans la structure de support (1), est ajustée pour contrôler les caractéristiques de la surface séparée (3) du support.

3. Procédé selon les revendications 1 ou 2,
**caractérisé en ce que**
les espèces (4) implantées dans la structure de support (1) sont choisies pour contrôler les caractéristiques de la surface séparée (3) du support.

4. Procédé selon les revendications 2 ou 3,
**caractérisé en ce que**
les paramètres du recuit thermique de la structure implantée de support (1) sont ajustés pour contrôler les caractéristiques de la surface séparée (3) du support.

5. Procédé selon l'une des revendications précédentes,
**caractérisé en ce que**
la structure de support (1) est séparée juste avant de former la couche épitaxiée (2).

6. Procédé selon l'une des revendications précédentes,
**caractérisé en ce que**
la structure de support (9), sur laquelle la couche épitaxiée (2) est formée, est une partie résiduelle de tranche d'une précédente tranche (7), dont une partie séparée forme la couche d'une autre structure de support (1) soudée dans laquelle la couche épitaxiée (2') est l'une de nitrure d'aluminium AlN, de GaAlN, de InGaN ou de GaN.

7. Procédé selon l'une des revendications précédentes,
**caractérisé en ce que**
la couche épitaxiée (2) est utilisée comme une couche tampon sur laquelle est formée une seconde couche épitaxiée (5).

8. Procédé selon la revendication 7,
**caractérisé en ce que**
la seconde couche épitaxiée (5) comprend un nitrure de gallium ou du nitrure de gallium combiné en alliage avec du InGaN et/ou du AlGaN.

9. Procédé selon la revendication 7,
**caractérisé en ce que**
la seconde couche épitaxiée (5) comprend un film de GeSi détendu.
